Europäisches Patentamt

European Patent Office

Office européen des brevets

(19)

(11) Publication number: **0 200 480**
**A2**

(12) # EUROPEAN PATENT APPLICATION

(21) Application number: **86303102.7**

(22) Date of filing: **24.04.86**

(51) Int. Cl.$^4$: **G 11 C 11/00**

(30) Priority: **24.04.85 JP 87718/85**

(43) Date of publication of application:
**05.11.86 Bulletin 86/45**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Arakawa, Hideki c/o Fujitsu Ltd.**
**Patent Department 1015 Kamikodanaka Nakahara-ku**
**Kawasaki-shi Kanagawa 211(JP)**

(74) Representative: **Billington, Lawrence Emlyn et al,**
**HASELTINE LAKE & CO Hazlitt House 28 Southampton**
**Buildings Chancery Lane**
**London WC2A 1AT(GB)**

(54) Non-volatile memory cell and non-volatile random access memory cell utilising the same.

(57) A non-volatile random access memory (NVRAM) cell includes a volatile static type random access memory cell (1) consisting of a flop-flip circuit ($Q_1$, $Q_2$, $Q_3$, $Q_4$) having two nodes ($N_1$, $N_2$) on which a paired bit signal can be accessed, and a non-volatile electrically erasable programmable read-only memory (EEPROM) cell (20) consisting of a memory transistor ($Q_8$) having a floating gate (FG), a capacitor circuit ($CM_2$, $TC_3$, $C_5$) to which a voltage ($V_{HH}$) called a writing voltage is applied, including a tunnel capacitor ($TC_3$), and two transistors ($Q_7$, $Q_{11}$) for determining the polarity of a charge to be stored at the floating gate (FG) with a tunnel current in the tunnel capacitor ($TC_3$) corresponding to the level of the bit signal existing at one of the two nodes ($N_2$) in the flip-flop circuit ($Q_1$, $Q_2$, $Q_3$, $Q_4$). When the power supply voltage ($V_{CC}$) of the NVRAM cell is turned off, the EEPROM cell (20) stores the positive or negative charge at the floating gate (FG) corresponding to the bit signal level at the node ($N_2$) in the flip-flop circuit holding the charge after the power supply ($V_{CC}$) voltage and the writing voltage ($V_{HH}$) are turned off. When the power supply voltage ($V_{CC}$) is turned on, the EEPROM cell (20) recalls the state of the flip-flop circuit so as to be the same as before using the charge stored at the floating gate.

FIG. 3

EP 0 200 480 A2

0200480

## NON-VOLATILE MEMORY CELL AND NON-VOLATILE

## RANDOM ACCESS MEMORY CELL UTILISING THE SAME

The present invention relates to a non-volatile memory cell and non-volatile random access memory (NVRAM) cell utilising the same.

Generally, in the art of semiconductor memory devices, an ideal semiconductor memory device has been awaited such that data can be re-written therein without limitation, access thereto can be made in a short time, and of a non-volatile type.

Generally, an SRAM cell has the advantage that the access time is short and the data can be re-written without limitation, but a disadvantage is that the cell is volatile. On the contrary, an EEPROM cell has the advantage that it is non-volatile, but the disadvantage that a long access time is required and the number of times data can be re-written is limited.

In an attempt to realize such an ideal semiconductor memory device, recently, an NVRAM cell has been proposed which combines the merits (properties) of the SRAM cell and the EEPROM cell. When the power supply voltage of the NVRAM cell is ON, using the advantageous properties / of the SRAM cell, the data can be written into or read out from the NVRAM cell in a short time, and also the data can be re-written without any limitation. When the power supply voltage of the NVRAM cell is turned off, using the / advantageous properties of the EEPROM cell, the data in the SRAM cell portion can be stored in the EEPROM cell portion, and the data stored in the EEPROM cell portion can be recalled to the SRAM cell portion when the power supply voltage is turned on. The / disadvantage of the long access time of the EEPROM cell has little effect on the NVRAM cell because the data access is required only for / the short time whilst the power supply voltage of the NVRAM cell is turned on and off.

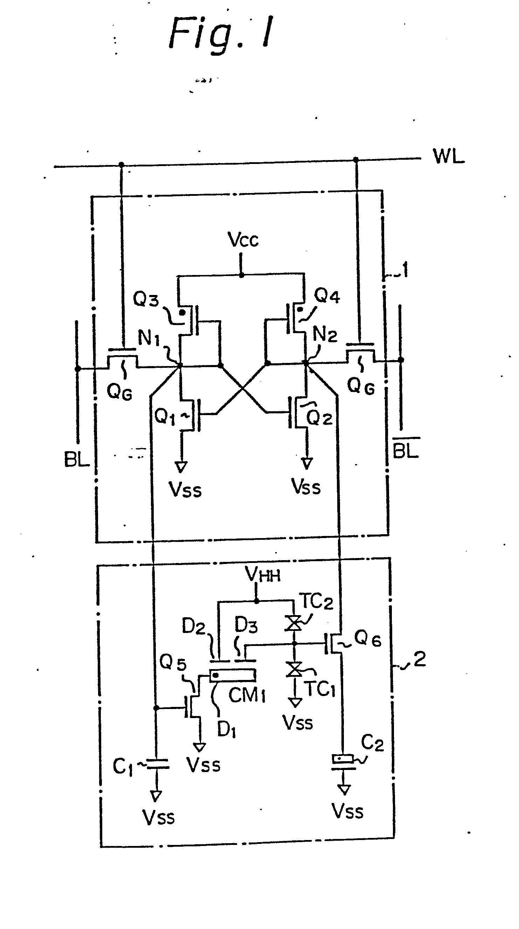

However, the NVRAM cell has a problem that its size becomes large; accordingly, proposals have been made to reduce the cell size for increasing the packing density of a memory device consisting of NVRAM cells. In the NVRAM cell, the SRAM cell portion therein / simply consists of / a few components of a flip-flop circuit, so that the EEPROM cell portion therein becomes a subject for increasing the packing density of the NVRAM cell. The U.S. Patent Appln. S.N. 659,191 invented by the inventor of the present invention gave a solution to the above problem by increasing the packing density of the EEPROM cell portion. According to the U.S. Patent Appln. S.N. 659,191, a prior art NVRAM cell is such as shown in Fig. 1 / of the accompanying drawings and an NVRAM

that
cell proposed in/ Patent Application is such as shown in Fig. 2(a).

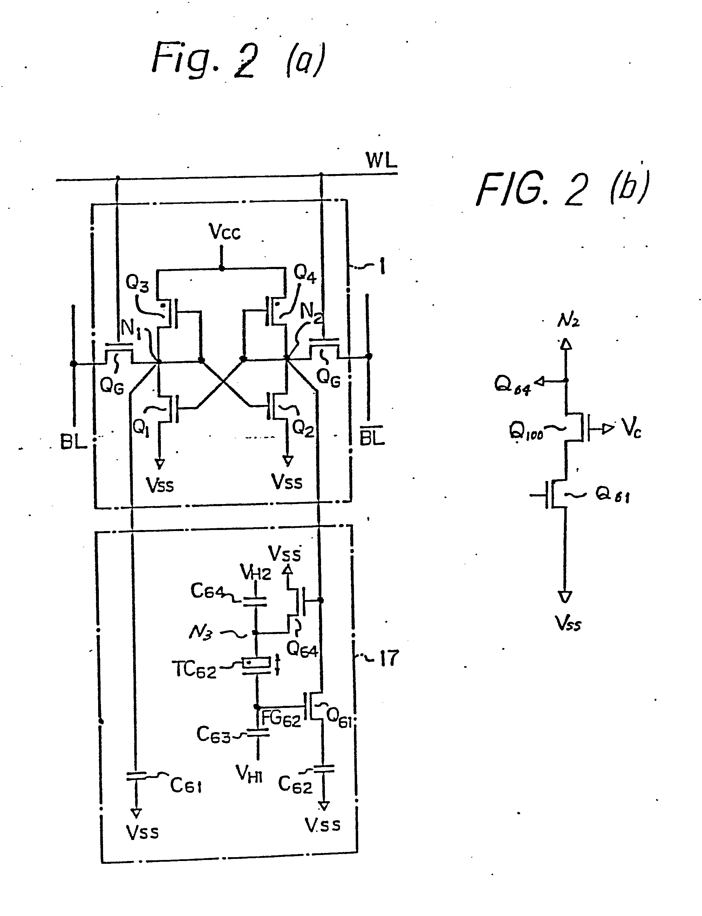

In Fig. 1 or 2(a), the NVRAM cell functions as a memory matrix element of a memory device, wherein the element is designated by /a respective word line WL and respective pair of bit lines BL and $\overline{BL}$ of the memory device. The NVRAM cell of Fig. 1 consists of an SRAM cell portion 1 and an EEPROM cell portion 2 and the NVRAM cell of Fig. 2(a) consists of an SRAM cell portion 1 and an EEPROM cell portion 17; the SRAM cell portions 1 of Figs. 1 and 2(a) are the same. Comparing Figs. 1 and 2(a), it can be seen that the improvement of the packing density of the NVRAM cell is achieved by reducing the circuit components of the EEPROM cell portion 2. Fig. 2(b) shows a modified partial circuit of Fig. 2(a); i.e., in Fig. 2(b), instead of removing the capacitor $C_{62}$ in Fig. 2(a), a control transistor $Q_{100}$ is placed between the node $N_2$ and the transistor $Q_{61}$. The details of the function of the NVRAM cell in Figs. 1, 2(a) and 2(b) are well discussed in U.S. Patent Appln. S.N. 659,191, so the explanation of these details is not repeated here.

In the U.S. Patent Appln. S.N. 659,191, many embodiments were disclosed, but in practice the NVRAM cell shown in Fig. 2(a) is most useful, because, as seen from Fig. 2(a), the NVRAM cell of Fig. 2(a) has the structure of removing the connection between the node $N_1$ of the SRAM cell portion 1 and the circuit of the EEPROM cell portion 2, so that the NVRAM cell of Fig. 2(a) is effective not only for increasing the packing density of the NVRAM cell but also for increasing the freedom for design of the structure of the NVRAM cell. However, as shown in Fig. 2(a), the EEPROM cell portion 17 operates with two kinds of power sources $V_{H1}$ and $V_{H2}$. The two kinds of power sources make the peripheral circuitry of the NVRAM cell a little more complicated, (which, however, is not so negative factor for the NVRAM cell of Fig. 2(a)). The two kinds of power supply voltage bring new problems to the NVRAM cell of Fig. 2(a) as follows.

(1) Two steps such as "pre-set" and "set" are necessary every time the floating gate $FG_{62}$ of the transistor $Q_{61}$ in the EEPROM cell portion 17 is charged or discharged for storing data, so that it takes a/ relatively long time to store the data.

(2) When a memory device consisting of a plurality of NVRAM cells is used as a read only memory (ROM) device, the two steps of "pre-set" and "set" must be carried/ out every time data is stored and recalled; accordingly, the life of the memory device is reduced. And,

(3) in a semiconductor device, a PN junction generally produces a leakage current, e.g., the leakage current flows at a node $N_3$ in Fig. 2(a), so that the holding time, which should be long for the NVRAM cell, of the capacitance-coupling-charge becomes short when the temperature at the PN junction increases. Therefore, repeating the charging of the floating gate again and again is necessary for lengthening the apparent holding time under the consideration of the upper allowable limit of the temperature characteristic of the NVRAM cell. However, the repeated charging cannot be carried out in the NVRAM cell of Fig. 2(a), because the floating gate $FG_{62}$ is always discharged every time new data is going to be stored in the EEPROM cell portion 17.

According to one aspect of the present invention there is provided a non-volatile memory cell comprising:

a memory transistor having a floating gate, operable to act as a switch in accordance with the polarity of a charge stored at said floating gate;

a capacitor circuit comprising a tunnel capacitor operatively connected to said floating gate;

means, operatively connected to said capacitor circuit, for applying a writing voltage having an amplitude large enough to cause a tunnel current to flow through said tunnel capacitor,

a first transistor, operatively connected to an input/output node of the cell and to said capacitor circuit, for controlling the polarity of said tunnel current in accordance with a data signal from said input/output node, said first transistor generating an output in response to said data signal;

a second transistor, operatively connected to said capacitor circuit receiving the output of said first transistor, for controlling the polarity of said tunnel current in accordance with said data signal;

said first and second transistors cooperatively controlling the polarity of the tunnel current when said writing voltage is applied to said capacitor circuit, one of said first and second transistors being ON and the other being OFF when said tunnel current is to flow, said polarity of the tunnel current being controlled to be in one of two directions depending on which one of said first and second transistors is ON, said two directions being such that said floating gate is provided with either a negative or a positive charge by said tunnel current, so as to store data corresponding to the data signal.

According to a further aspect or development of the invention, there is provided a non-volatile random-access memory cell by combining the non-volatile memory cell of the preceding paragraph with a volatile memory cell comprising:

a flip-flop circuit having first and second nodes from which, in use, complementary data signals corresponding to data stored in the volatile memory cell are output, and

a capacitor connected to the first node;

wherein the second node of the volatile memory cell is connected to the input/output node of the non-volatile memory cell, whereby data can be transferred between the volatile memory cell and the non-volatile memory cell.

Further aspects of the invention provide non-volatile random access memory cells as defined in claims 5 and 6.

An embodiment of the present invention may provide an NVRAM cell constituted by a volatile static type random-access memory (SRAM) cell portion and a non-volatile electrically erasable programmable read-only memory (EEPROM) cell portion.

An embodiment of the present invention may increase the packing density of a memory device consisting of NVRAM cells whilst keeping the reliability high.

An embodiment of the present invention may give more freedom in the design of the semiconductor structure of the NVRAM cell.

An embodiment of the present invention may increase the yield rate of production of memory devices consisting of NVRAM cells.

An embodiment of the present invention may reduce the time for storing or re-calling data into or out from the EEPROM cell portion of an NVRAM cell.

An embodiment of the present invention may increase the life of an NVRAM cell.

An embodiment of the present invention may/provide an NVRAM cell in which repetition of the charging for storing a datum/(item of data) can be made any number of times.

In /embodiments of the present invention there may be provided an improved EEPROM cell portion combined with an SRAM cell portion. The improved EEPROM cell portion operates under only one power supply voltage called a writing voltage when the power supply voltage for the SRAM cell portion is intended to be turned off. The improved EEPROM cell portion comprises: a memory transistor having a floating gate on which charge is stored /such that the polarity of the charge is determined in correspondence with the level of the bit signal at one node of the flip-flop circuit in the SRAM cell portion; a capacitor circuit comprising a tunnel capacitor; and two transistors for controlling the polarity of the charge being stored at the floating gate in cooperation with a tunnel current of the tunnel capacitor.

Reference is made, by way of example, to the accompanying drawings in which:

Fig. 1 is a circuit diagram of a /previously proposed NVRAM cell;

Fig. 2(a) is a circuit diagram of another /previously proposed NVRAM cell;

Fig. 2(b) is a modified partial circuit of Fig. 2(a);

Fig. 3 is a circuit diagram embodying the present invention; and

Fig. 4 is another circuit diagram embodying the present invention.

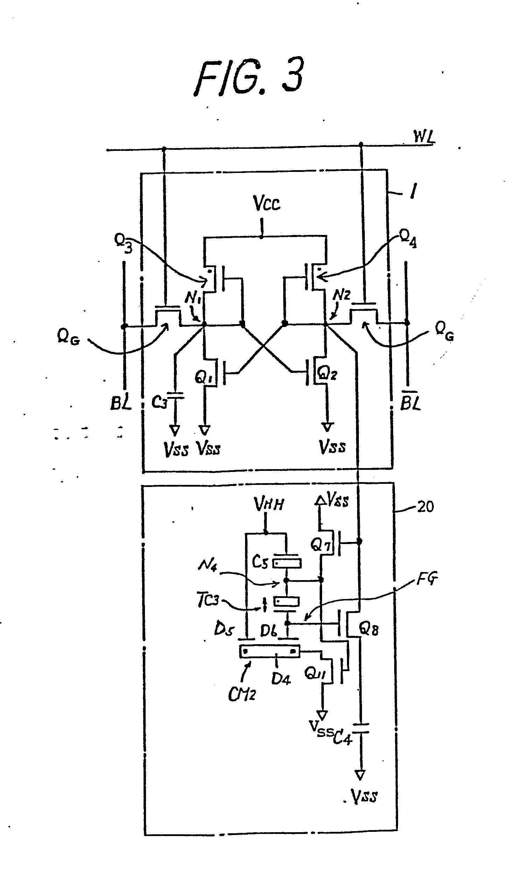

Fig. 3 shows a circuit diagram of an NVRAM cell embodying the present invention. In Fig. 3, the same reference numerals and symbols as in Figs. 1 and 2(a) designate similar elements or parts to those in Figs. 1 and 2(a). The NVRAM cell consists of an SRAM cell portion 1, which may be the same as SRAM cell portion 1 in Fig. 1 or 2(a), and an EEPROM cell portion 20. A plurality of the NVRAM cells 1 form a memory device (an NVRAM device) having the structure of a memory matrix, and each NVRAM cell is designated by a respective word-line WL and respective pair of bit-lines BL and $\overline{BL}$.

The SRAM cell portion 1 comprises four metal insulator semiconductor (MIS) transistors $Q_1$, $Q_2$, $Q_3$, and $Q_4$ (the transistors $Q_1$ and $Q_2$ are the ordinary enhancement type, and the transistors $Q_3$ and $Q_4$ are the depletion type which are distinguished from the enhancement type in the Figure by a black dot) which are cross-coupled at nodes $N_1$ and $N_2$ forming an ordinary flip-flop circuit. Complementary data signals such as a paired bit signals are written into the flip-flop circuit from the bit-lines BL and $\overline{BL}$ or read out from the flip-flop circuit to the bit-lines BL and $\overline{BL}$ through two transfer gate MIS transistors $Q_G$ connected to the nodes $N_1$ and $N_2$.

The EEPROM cell portion 20 is a non-volatile memory cell which comprises a memory MIS transistor $Q_8$ having a floating gate FG, the MIS transistors $Q_7$ and $Q_{11}$, and a capacitor circuit consisting of a capacitor module $CM_2$, capacitors $C_4$ and $C_5$, and tunnel capacitor $TC_3$. The capacitor module $CM_2$, the tunnel capacitor $TC_3$, and the capacitor $C_5$ are made from depletion type MIS transistors (each/having a black dot) each having/ their drain and source connected together. The capacitor module $CM_2$ has static capacitance between a common electrode $D_4$ and an electrode $D_5$ and/the common electrode $D_4$ and an electrode $D_6$; the tunnel capacitor $TC_3$ is a capacitor/function by a tunnel effect and whose capacitance is selected so as to be sufficiently small / compared with the capacitance of the capacitor module $CM_2$ and the capacitor $C_5$; and the capacitor $C_4$ is selected/ sufficiently large compared with that of the capacitor $C_3$ of the SRAM cell portion 1. The transistors $Q_7$ and $Q_{11}$ each function as a switch corresponding to a signal level H or L applied to the gate; however, they operate oppositely to each other, i.e., the transistor $Q_{11}$ switches OFF and ON corresponding to ON and OFF operations of the transistor $Q_7$.

The operation of this NVRAM cell embodying the present invention is divided into/following modes: (1) Store Mode 1 (The mode of storing a datum /in the SRAM cell portion 1 into the EEPROM cell portion 20 when the potential at the

node $N_1$ is L and that at the node $N_2$ is H), (2) Store Mode 2 (The    store mode    when the potential at the node $N_1$ is H and that at the node $N_2$ is L), (3) Recall Mode 1 (The mode of recalling the data    stored in the EEPROM cell portion 20 back to the SRAM cell portion 1 when    a negative charge is stored at the floating gate FG of the transistor $Q_8$), and (4) Recall Mode 2 (The same recall mode but when    a positive charge is stored at floating gate FG). In / these modes, the NVRAM cell operates as follows.

(1)    Store Mode 1

The writing voltage $V_{HH}$ / is raised up to 20 - 30 volt (V) from 0 V, before turning the power supply voltage $V_{CC}$ off. At this time, since the voltage at the node $N_2$ is "H", the transistor $Q_7$ is ON (reference symbol $V_{SS}$ is a low potential such as    earth potential), so that the potential at the node $N_4$ becomes L and the transistor $Q_{11}$ becomes OFF. Accordingly, the writing voltage $V_{HH}$ is applied to a series circuit consisting of the capacitor formed between the electrodes $D_4$ and $D_5$, the capacitor formed between the electrodes $D_4$ and $D_6$, and the tunnel capacitor $TC_3$. As mentioned before, the static capacitance of the capacitor module $CM_2$ is sufficiently larger than that of the tunnel capacitor $TC_3$ so that the / greater part of the writing voltage $V_{HH}$ is applied to the tunnel capacitor $TC_3$. At this time, electrons move from the node $N_4$ to the floating gate FG of the transistor $Q_8$ through the tunnel capacitor $TC_3$ by the tunnel effect, so that a    negative charge is stored at the floating gate FG, which makes the transistor $Q_8$ OFF, and the negative charge stored at the floating gate FG is retained /for a long period, even though the power supply voltage $V_{CC}$ and the writing voltage $V_{HH}$ are turned off. Thus, the data in the SRAM cell portion 1 can be completely stored in the EEPROM cell portion 20. From the above, the transistor $Q_8$ is called a memory transistor.

(2) Store Mode 2

Since the potential at the node $N_2$ is L, the transistor $Q_8$ becomes OFF, so that the node $N_4$ goes into a floating state; however, when the writing voltage $V_{HH}$ is applied, the potential at the node $N_4$ rises up, which turns ON the transistor $Q_{11}$. Accordingly, the writing voltage $V_{HH}$ is applied to the series circuit consisting of the capacitor $C_5$, the tunnel capacitor $TC_3$, and the capacitor formed between the electrodes $D_4$ and $D_6$. Thus the greater part of the writing voltage $V_{HH}$ is applied to the tunnel capacitor $TC_3$, because the capacitance of the tunnel capacitor is sufficiently small compared with/the other capacitance of the capacitors in the series circuit as mentioned before. In this case, since the potential at the node $N_4$ is higher than that at the floating gate FG, the electrons which existed at the floating gate FG are extracted by the tunnel effect of the tunnel capacitor $TC_3$; accordingly, a positive charge is stored at the floating gate FG making the transistor $Q_8$ ON. The positive charge stored at the floating gate FG is retained for a long period. Thus, the data in the SRAM cell portion 1 can be completely stored into the EEPROM cell portion 20.

(3) Recall Mode 1

First, the power supply voltage $V_{CC}$ for the memory cell 1 is set to 0 V. At this time, since a negative charge exists at the floating gate FG, the transistor $Q_8$ is cut off, disconnecting the connection between the node $N_2$ and the capacitor $C_4$. Therefore, when the power supply voltage $V_{CC}$ (5 V) is turned on, since the capacitor $C_3$ is connected to the node $N_1$ and the capacitor $C_4$ is disconnected from the node $N_2$, the potential at the node $N_1$ becomes L because only the load at the node $N_1$ is heavy, and the potential at the node $N_2$ becomes H. Thus, the data stored in the EEPROM cell portion 20 is recalled to the NVRAM cell when the power supply voltage is turned on.

(4) Recall Mode 2

First, the power supply voltage $V_{CC}$ for the memory cell 1 is set to 0 V. At this time, a positive charge exists at the floating gate FG, so that the transistor $Q_8$ is ON connecting the node $N_2$ to the capacitor $C_4$. Therefore, when the power supply voltage $V_{CC}$ (5 V) is turned on, since the capacitance of the capacitor $C_4$ is selected so as to be larger than that of the capacitor $C_3$, the flip-flop circuit in the SRAM cell portion 1 functions so that the potential at the $N_1$ becomes H and that at the $N_2$ becomes L. Thus,

the data stored in the EEPROM cell portion 20 is recalled to the NVRAM cell when the power supply voltage is turned on.

As seen from the above discussion, the EEPROM cell portion 20 uses only one writing voltage $V_{HH}$; therefore, it does not share the problems/ which the NVRAM cell, shown in Fig. 2, had. That/the problems of the / previously proposed NVRAM cell is, taking too much time to store and recall data, having a short life and being difficult to give enough holding time, may all be solved in this embodiment of the present invention.

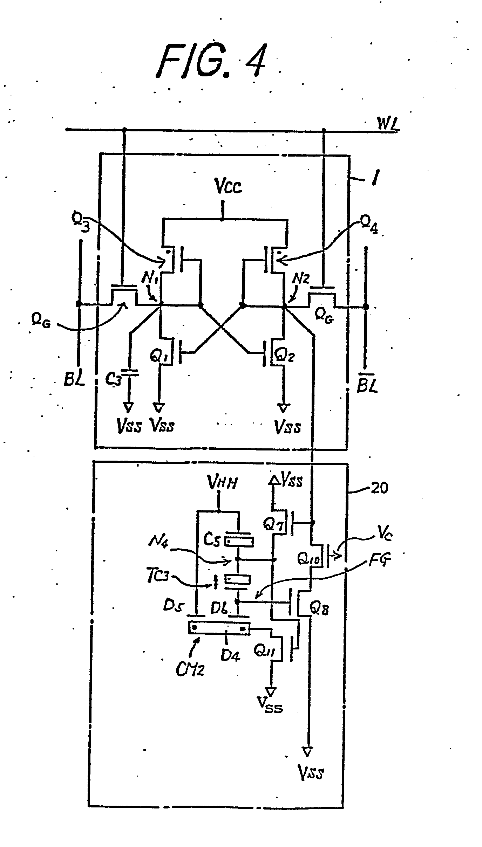

Fig. 4 is a circuit diagram of an NVRAM cell showing another embodiment of the present invention. The function and the operation of Fig. 4 are / similar to those of Fig. 3. In Fig. 4, the circuit from the node $N_2$ to the earth potential $V_{SS}$ through the transistor $Q_8$ and the capacitor $C_4$ in Fig. 3 is modified in a / similar way to the modified partial circuit shown in Fig. 2(b); i.e., the capacitor $C_4$ in Fig. 3 is omitted, and a control transistor $Q_{10}$ is placed between the node $N_2$ and the transistor $Q_8$ for switching the connection between the node $N_2$ and the memory transistor $Q_8$; the switching action is made by a control voltage $V_C$ applied to the gate of the transistor $Q_{10}$.

As mentioned above, an embodiment of the present invention provides
/ a non-volatile random access memory (NVRAM) cell including a volatile static type random access memory cell consisting of a flop-flip circuit having two nodes on which a paired bit signal /$^{may\ be}$ accessed and a non-volatile electrically erasable programmable read-only memory (EEPROM) cell consisting of a memory transistor having a floating gate, a capacitor circuit, to which a voltage called a writing voltage is applied, including a tunnel capacitor, and two transistors for determining the polarity of charge$_{\wedge}$$^{S}$ to be stored at the floating gate with a tunnel current in the tunnel capacitor corresponding to the level of the bit signal existing at one of the two nodes in the flip-flop circuit. When the power supply voltage of the NVRAM cell is turned off, the EEPROM cell stores the positive or negative charge at the floating gate corresponding to the bit signal level at the node in the flip-flop circuit holding the charge after the power supply voltage and the writing voltage are turned off. When the power supply voltage is turned on, the EEPROM cell recalls the the state of the flip-flop circuit so as to be/$^{the}$same as before using the charge stored at the floating gate.

Claims:

1. A non-volatile memory cell comprising:

a memory transistor having a floating gate, operable to act as a switch in accordance with the polarity of a charge stored at said floating gate;

a capacitor circuit comprising a tunnel capacitor operatively connected to said floating gate;

means, operatively connected to said capacitor circuit, for applying a writing voltage having an amplitude large enough to cause a tunnel current to flow through said tunnel capacitor,

a first transistor, operatively connected to an input/output node of the cell and to said capacitor circuit, for controlling the polarity of said tunnel current in accordance with a data signal from said input/output node, said first transistor generating an output in response to said data signal;

a second transistor, operatively connected to said capacitor circuit receiving the output of said first transistor, for controlling the polarity of said tunnel current in accordance with said data signal;

said first and second transistors cooperatively controlling the polarity of the tunnel current when said writing voltage is applied to said capacitor circuit, one of said first and second transistors being ON and the other being OFF when said tunnel current is to flow, said polarity of the tunnel current being controlled to be in one of two directions depending on which one of said first and second transistors is ON, said two directions being such that said floating gate is provided with either a negative or a positive charge by said tunnel current, so as to store data corresponding to the data signal.

2. A non-volatile memory cell as claimed in claim 1, and further comprising a loading capacitor connected between the memory transistor and a low-voltage power supply line.

3. A non-volatile memory cell as claimed in claim 1, and further comprising a transistor, connected between said input/output node and said memory transistor, for switching the connection between said input/output node and said memory transistor.

4. A non-volatile random acess memory cell comprising:

a non-volatile memory cell as claimed in claim 1, 2, or 3; and

a volatile memory cell comprising:

a flip-flop circuit having first and second nodes from which, in use, complementary data signals corresponding to data stored in the volatile memory cell are output, and

a capacitor connected to the first node;

wherein the second node of the volatile memory cell is connected to the input/output node of the non-volatile memory cell, whereby data can be transferred between the volatile memory cell and the non-volatile memory cell.

5.    A non-volatile random access memory cell comprising:

a volatile memory cell, for storing data, comprising :

a flip-flop circuit having   first and second nodes from   in use,
which, complementary signals corresponding to the stored data   are output, and

a first capacitor connected to said first node;

and

a non-volatile memory cell comprising :

be
a second capacitor, operable to/connected to said second node, having a capacitance larger than that of said first capacitor,

a memory transistor having a floating gate, connected between said second node and said second capacitor, said memory transistor acting as a switch in accordance with the polarity of  a  charge stored at said floating gate,

a capacitor circuit comprising a tunnel capacitor connected to said floating gate,

means,             .connected to said capacitor circuit, for applying a writing voltage having an amplitude large enough to cause a tunnel current to flow through said tunnel capacitor,

a first transistor,              connected to said second node and to said capacitor circuit, for controlling the polarity of said tunnel current in accordance with said stored .data  said first transistor generating an output in response to one of said complementary signals at said second node, and

a second transistor,           connected to said capacitor circuit receiving the output of said first transistor, for controlling the polarity of said tunnel current in accordance with said stored `data,

said first and second transistors cooperatively controlling the polarity of the tunnel current to flow through said tunnel capacitor when said writing voltage is applied to said capacitor circuit, one of said first and second transistors being ON and the other being OFF when said tunnel current is to  flow , said polarity of the tunnel current being controlled to be in one of two directions opposite to each other depending on which one of said first and second transistors is ON, said two directions being such that said floating gate is provided with either a negative or a positive charge.

6.    A non-volatile random access memory cell comprising:

a volatile memory cell, for storing   data, comprising :

a flip-flop circuit having · first and second nodes from / which, in use, complementary signals corresponding to the stored data  are output, and

a first capacitor connected to said first node; and

a non-volatile memory cell comprising

a memory transistor having a floating gate, connected to said second node, said memory transistor acting as a switch in accordance with the polarity of a charge stored at said floating gate,

a capacitor circuit comprising a tunnel capacitor connected to said floating gate,

means, connected to said capacitor circuit, for applying a writing voltage having an amplitude large enough to cause a tunnel current to flow through said tunnel capacitor,

a first transistor, connected to said second node and to said capacitor circuit, for controlling the polarity of said tunnel current in accordance with said stored data said first transistor generating an output in response to one of said complementary signals at said second node,

a second transistor, connected to said capacitor circuit receiving the output of said first transistor, for controlling the polarity of said tunnel current in accordance with said stored data and

a third transistor, connected between said second node and said memory transistor, for switching the connection between said second node and said memory transistor,

said first and second transistors cooperatively controlling the polarity of the tunnel current to flow through said tunnel capacitor when said writing voltage is applied to said capacitor circuit, one of said first and second transistors being ON and the other being OFF when said tunnel current is to flow, said polarity of the tunnel current being controlled to be in one of two directions opposite to each other depending on which one of the first and second transistors is ON, said two directions being such that said floating gate is provided with either a negative or a positive charge.

7.    A non-volatile random access memory cell according to claim 4, 5 or 6, wherein said first transistor is operable under a power supply voltage applied to said non-volatile memory cell against earth potential and said first transistor has its gate connected , to said second node and its drain connected to said earth potential.

8.  A non-volatile random access memory cell according to claim 4, 5, 6, or 7, wherein said second transistor is operable under a power supply voltage applied to said non-volatile  memory cell against earth potential and said second transistor has its drain connected to said earth potential.

9.    A non-volatile random access memory cell according to any one of claims 4 to 8, wherein said volatile memory cell is a volatile static type random access memory cell and said non-volatile memory cell is a non-volatile electrically erasable programmable read-only memory cell.

10. A non-volatile memory cell according to claim 1, 2 or 3, or a non-volatile random access memory cell according to any one of claims 4 to 9, wherein said capacitor circuit of said non-volatile memory cell further comprises:

a third capacitor, one side electrode thereof being connected to said writing voltage and the other side electrode thereof being connected to one side electrode of said tunnel capacitor, the source of said first transistor, and the gate of said second transistor, and

a capacitor module having a common electrode, a first electrode forming a fourth capacitor with said common electrode, and a second electrode forming a fifth capacitor with said common electrode, said first electrode being connected to said writing voltage, said common electrode being connected to the source of said second transistor, and said second electrode being connected to said floating gate and the other side electrode of said tunnel capacitor.

# Fig. I

2/4

0200480

Fig. 2 (a)

FIG. 2 (b)

# FIG. 3

# FIG. 4